# EUROPÄISCHE PATENTANMELDUNG

(11) **EP 3 112 826 A1**
(43) Veröffentlichungstag der Anmeldung: **04.01.2017**
(21) Anmeldenummer: 15174970.2
(22) Anmeldetag: 02.07.2015
(51) Int. Cl.: G01H 1/00, G01H 3/00, G01V 3/08, G01V 3/165

(54) **VERFAHREN UND UMRICHTER ZUR LOKALISIERUNG EINER AN EINEM UMRICHTER ANGESCHLOSSENEN ELEKTRISCHEN MASCHINE ODER ZUR IDENTIFIZIERUNG EINES AN DER ELEKTRISCHEN MASCHINE ANGESCHLOSSENEN UMRICHTERS**

(71) Anmelder: Siemens Aktiengesellschaft, 80333 München (DE)
(72) Erfinder: Scheibner, Dirk, 90473 Nürnberg (DE); Schimmer, Jürgen, 90473 Nürnberg (DE)

(57) **Zusammenfassung**

Die Erfindung betrifft ein Verfahren und einen Umrichter zur Lokalisierung einer an dem Umrichter (U) angeschlossenen elektrischen Maschine (M) oder zur Identifizierung des an der elektrischen Maschine (M) angeschlossenen Umrichters (U). Dabei wird mittels eines Leistungsausgangs des Umrichters (U) die elektrische Maschine (M) mit einem elektrischen Signal beaufschlagt, wobei das elektrische Signal eine derartige Amplitude, Phase und einen derartigen Signalverlauf aufweist, dass die elektrische Maschine (M) zur Abgabe einer mechanischen oder akustischen Schwingung oder zum Aufbau eines magnetischen oder eines elektrischen Feldes in ihrer Umgebung angeregt wird. Dadurch ist es möglich, die jeweilige an dem Umrichter angeschlossene elektrische Maschine berührungslos zu lokalisieren und das Signal und damit auch den das Signal sendenden Umrichter zu identifizieren.

## Beschreibung

Die Erfindung betrifft ein Verfahren zur Lokalisierung einer an einem Umrichter angeschlossenen elektrischen Maschine gemäß dem Oberbegriff des Patentanspruchs 1 und einen Umrichter zur Lokalisierung der elektrischen Maschine gemäß dem Oberbegriff des Patentanspruchs 10.

Elektrische Maschinen (Elektromotoren, elektrische Generatoren) werden in industriellen Anordnungen, insbesondere in Automatisierungsanordnungen und dergleichen, mittels sogenannter Umrichter (auch Stromrichter genannt) an ein Energieversorgungsnetz angeschlossen. Der Umrichter erzeugt dabei für die elektrischen Motoren ein je nach geforderter Drehzahl und Drehmoment geeignetes elektrisches Drehfeld an seinen Ausgangsklemmen bzw. richtet die in einem Generatorbetrieb von der elektrischen Maschine erzeugte elektrische Energie so um, dass diese in das elektrische Energieversorgungsnetz eingespeist oder in Wärme umgewandelt werden kann. Die gebräuchlichen Umrichter sind dabei meist in Schaltschränken oder Schalträumen untergebracht, wobei mittels elektrischer Leitungen die davon abgesetzt montierten Motoren bzw. Generatoren an den Umrichtern angeschlossen sind. Dabei sind in gebräuchlichen Automatisierungsanordnungen jeweils eine Vielzahl von Umrichtern und eine Vielzahl an elektrischen Maschinen im Einsatz.

Beim Errichten der industriellen Anlagen mit elektrischen Antrieben bzw. elektrischen Generatoren wird das Verlegen der Leitungen und die Inbetriebnahme in der Regel von verschiedenen Personen durchgeführt. Ein Inbetriebnehmer muss deshalb insbesondere bei großen Abständen zwischen Umrichtern und Motoren prüfen, ob die jeweilige Leitung wirklich zum geplanten Motor führt, oder ob etwa eine Verwechslung oder falsche Zuordnung vorliegt. Dies ist mit hohem manuellem Aufwand verbunden. Zudem muss beim Durchmessen der Leitungen in geöffneten Klemmenkästen gearbeitet werden, was entweder ein oft nicht gewolltes Freischalten der Leitungen bedingt, oder anderenfalls ein Sicherheitsrisiko für die beteiligten Personen darstellt.

Es ist eine Aufgabe der vorliegenden Erfindung, eine einfache und sichere Alternative zum sonst üblichen Durchmessen der Leitungen anzugeben, wobei diese Methode ohne Öffnen der Klemmenkästen eine dennoch sichere Lokalisierung oder Identifikation des angeschlossenen Motors bzw. des an dem Motor angeschlossenen Umrichters ermöglichen soll.

Es ist eine Kernidee der erfindungsgemäßen Lösung dieser Aufgabe, durch den Umrichter über die Leistungsleitung, also über die Klemmen, an denen die Wicklungen der elektrischen Maschinen angeschlossen sind, Signale an die elektrische Maschine auszugeben, die an der elektrischen Maschine auf sichere Weise und vorzugsweise berührungslos detektiert werden können. Somit kann die Zuordnung zwischen dem jeweiligen Umrichter und der jeweiligen elektrischen Maschine eindeutig bestätigt oder eine eindeutige Identifizierung vorgenommen werden. Überdies ist es damit möglich, einen an dem Umrichter angeschlossenen Motor oder Generator überhaupt zu lokalisieren. Dabei sind die Signale, die auf die Leistungsleitungen gegeben werden, vorzugsweise so gestaltet, dass auch bei Verwechslungen keine Schäden am angeschlossenen Motor/Generator auftreten können, wobei insbesondere ein Anlaufen (Drehen) der angeschlossenen elektrischen Maschine allein aufgrund der Identifizierungssignale ausgeschlossen werden soll. Darüber hinaus entfällt das sonst erforderliche manuelle Durchmessen von Leitungen, wobei darüber hinaus für das Verfahren auch keine Modifikationen an dem Motor und auch nicht das Verlegen zusätzlicher Signalleitungen erforderlich sind und wobei eine hohe Arbeitssicherheit gewährleistet ist, da auf keine spannungsführenden Teile am Motor (motorseitiger Klemmenkasten) oder am Umrichter (Schaltschrank) zugegriffen werden muss. Es ist also erfindungsgemäß nicht notwendig, einzelne oder alle Anlagenteile spannungsfrei zu schalten.

Die Aufgabe wird insbesondere durch ein Verfahren nach Patentanspruch 1 und durch einen Umrichter nach Patentanspruch 10 gelöst.

Dabei wird ein Verfahren zur Lokalisierung einer an einem Umrichter angeschlossenen elektrischen Maschine oder zur Identifizierung des an der elektrischen Maschine angeschlossenen Umrichters vorgeschlagen, wobei mittels eines Leistungsausgangs des Umrichters die elektrische Maschine mit einem elektrischen Signal beaufschlagt wird und wobei das elektrische Signal eine derartige Amplitude, Phase und einen derartigen Signalverlauf aufweist, dass die elektrische Maschine zur Abgabe einer mechanischen oder akustischen Schwingung oder zum Aufbau eines äußeren magnetischen oder eines äußeren elektrischen Feldes angeregt wird. Dadurch ist es möglich, die jeweilige an dem Umrichter angeschlossene elektrische Maschine berührungslos zu lokalisieren und das Signal und damit auch den das Signal sendenden Umrichter zu identifizieren.

Die Aufgabe wird außerdem durch einen Umrichter zur Lokalisierung einer an dem Umrichter angeschlossenen elektrischen Maschine oder zur Identifizierung des an der Maschine angeschlossenen Umrichters gelöst, wobei der Umrichter zur Beaufschlagung eines Leistungsausgangs mit einem elektrischen Signal eingerichtet ist, wobei das elektrische Signal eine derartige Amplitude und einen derartigen Signalverlauf aufweist, dass die elektrische Maschine zur Abgabe einer mechanischen oder akustischen Schwingung oder zum Aufbau eines äußeren elektrischen oder magnetischen Feldes angeregt wird und wobei das Signal derart ausgestaltet ist, dass ein Drehen eines Rotors der elektrischen Maschine nicht erfolgt und/oder eine Beschädigung der elektrischen Maschine durch das Signal ausgeschlossen ist. Durch einen solchen Umrichter können die bereits anhand des Verfahrens erläuterten Vorteile realisiert werden.

Vorteilhafte Ausgestaltungen des erfindungsgemäßen Verfahrens sind in den abhängigen Patentansprüchen angegeben. Die dabei erwähnten Merkmale und Vorteile gelten sinngemäß auch für den erfindungsgemäßen Umrichter. Die geschilderten vorteilhaften Varianten können sowohl einzeln, als auch in Kombination miteinander realisiert werden.

Vorteilhaft ist das Signal derart ausgestaltet, dass ein Drehen eines Rotors der elektrischen Maschine nicht erfolgt und/oder eine Beschädigung der elektrischen Maschine durch das Signal ausgeschlossen ist. Dies kann dadurch erreicht werden, dass die Amplitude des Signals so gering gewählt wird, dass keine zerstörerische elektrische Leistung bei dem Prüfvorgang in die elektrische Maschine eingespeist wird. Überdies kann das Signal derart gewählt werden, dass kein derart starkes Drehfeld erzeugt wird, welches die Maschine zum Anlaufen bringen könnte. Es kann darüber hinaus auch vorgesehen sein, die Signalabgabe an die elektrische Maschine zeitlich zu beschränken, wobei nach einem Identifizierungszyklus eine Pause ("Abkühlpause") vorgesehen wird.

Während es für einfache Lokalisierungen oder Identifizierungen ausreichen kann, wenn überhaupt ein detektierbares Signal an die elektrische Maschine abgegeben wird, ist es insbesondere bei komplexen Automatisierungsanordnung mit vielen Umrichtern und elektrischen Maschinen von Vorteil, wenn das Signal derart ausgebildet wird, dass es anhand seines Signalverlaufs, insbesondere anhand einer Frequenz und/oder anhand eines Pulsmusters oder dergleichen zur Identifizierung und damit auch zur Unterscheidung von anderen Signalen benachbarter Umrichter bzw. für benachbarte elektrische Maschinen unterscheidbar ist.

Während in einem einfachen Fall eine durch das Verfahren erzeugte mechanische Schwingung oder ein von der elektrischen Maschine abgestrahltes akustisches Signal von einer Bedienperson direkt gespürt oder gehört werden kann, ist es insbesondere für die Zwecke der Identifizierung von Vorteil, wenn dafür ein mobiles Gerät mit einem Sensor eingesetzt wird, insbesondere mit einem Schwingungssensor für mechanische Schwingungen oder Körperschall, mit einem Mikrofon für akustische Schwingungen (Luftschall), mit einem Magnetfeldsensor für magnetische Felder bzw. magnetische Wechselfelder und/oder mit einem Feldsensor für elektrische Felder bzw. Wechselfelder. Solche Sensoren können entweder direkt in dem mobilen Gerät eingebaut sein, oder aber an ein solches mobiles Gerät angesteckt oder per Funk (z.B. Bluetooth) mit dem mobilen Gerät gekoppelt werden. Insbesondere ist es von Vorteil, wenn als das mobile Gerät ein ohnehin bereits bekanntes und vorhandenes mobiles Gerät eingesetzt wird, beispielsweise ein Smartphone, ein Tablet-PC, oder ein mobiles Bedien- und Beobachtungsgerät ("HMI-Gerät") für industrielle Automatisierungsanordnungen. Dabei weist das mobile Gerät vorzugsweise eine Software zur Dekodierung des aufgenommenen Signals auf, beispielsweise eine Software zur Impulsverarbeitung, zur Frequenzzählung oder dergleichen. Insbesondere kann die Software für einen Vergleich des von dem Umrichter abgegebenen Signals mit dem mittels des Sensors aufgenommenen Signals durchgeführt werden, wozu es zweckmäßig ist, wenn eine Beschreibung oder ein Datenstrom des vom Umrichter emittierten Signals an das mobile Gerät für die Vergleichszwecke übertragen wird. Dies ist insbesondere nützlich, wenn in einer Anordnung mehrere Umrichter verschiedene Signale an verschiedene elektrische Maschinen abgeben, weil hierbei durch den Vergleich die Identifizierung desjenigen Umrichters möglich ist, der mit der elektrischen Maschine verbunden ist, die gerade durch den Sensor abgetastet oder erfasst wird.

Insbesondere zur Vermeidung eines ungewollten Andrehens der elektrischen Maschine ist es von Vorteil, wenn der Umrichter an seinen Ausgangsklemmen ein gleichphasiges Signal abgibt, wobei dieses Signal derart ausgestaltet sein soll, dass die damit angesteuerte elektrische Maschine ein äußeres elektrisches oder ein äußeres magnetisches Feld aufbaut, so dass durch die Erfassung eines solchen Feldes berührungslos in der Umgebung der elektrischen Maschine eine Identifizierung vorgenommen werden kann.

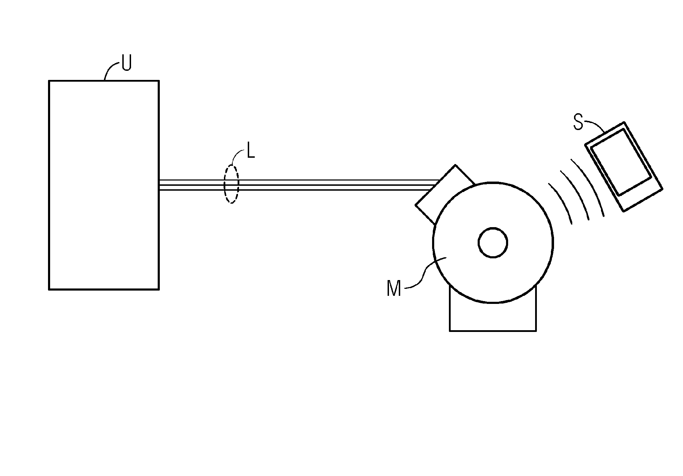

Ein Ausführungsbeispiel des erfindungsgemäßen Verfahrens wird nachfolgend anhand der Zeichnung erläutert. Dieses Ausführungsbeispiel dient gleichzeitig der Erläuterung eines erfindungsgemäßen Umrichters.

Dabei zeigt die einzige Figur schematisch eine Anordnung aus einem Umrichter und einer elektrischen Maschine, die mit einer Leistungsleitung miteinander verbunden sind, sowie ein mobiles Gerät zur Aufnahme und Verarbeitung der von der elektrischen Maschine emittierten Signale.

In der Figur ist ein elektrischer Umrichter U (auch Stromrichter genannt) dargestellt, der primärseitig (nicht dargestellt) mit einem elektrischen Energieversorgungsnetz verbunden ist. Sekundärseitig, also an seinen sogenannten Leistungsklemmen ist er über einen Satz Anschlussleitungen L mit einer elektrischen Maschine M (hier: elektrischer Motor) verbunden. Wie hier dargestellt, kann es sich bei den Leitungen L um einen dreipoligen Leitungssatz für ein elektrisches Drehfeld in Dreieckschaltung handeln; in einer anderen gebräuchlichen Anordnung sind jedoch zwei Leiter für jede Wicklung der Maschine M üblich, also in Summe zumindest sechs Leitungen. Die Leitungen führen über einen Klemmenkasten der elektrischen Maschine M auf die zumindest drei Ständerwicklungen; in einer alternativen Ausführungsform können auch weitere Leiter mit Rotorwicklungen verbunden sein. In der Figur ist weiterhin ein mobiles Gerät S (hier: ein Smartphone) dargestellt, welches in unmittelbarer Nähe der elektrischen Maschine M mit seinem eingebauten Mikrofon die von der Maschine M abgestrahlten Schallsignale erfasst und verarbeitet.

Der Umrichter U schickt nun über die Leitung L Signale an die elektrische Maschine M, die an der elektrischen Maschine M auf verschiedene Weise sicher detektiert werden können. Im vorliegenden Ausführungsbeispiel wird durch den Umrichter U ein elektrisches Wechselsignal auf genau eine Wicklung der elektrischen Maschine M gegeben, wobei dieses Signal Frequenzen im akustisch hörbaren Bereich aufweist und eine derartige Amplitude hat, dass die Maschine M ein entsprechendes Schallsignal mit einer hörbaren Amplitude emittiert. Dadurch, dass nur eine Wicklung der Maschine M mit dem Signal beaufschlagt wird, entsteht kein Drehfeld, so dass der Motor M nicht anläuft und somit auch durch ein unbeabsichtigtes Anlaufen keine Schäden entstehen können.

Das von dem Umrichter erzeugte bzw. abgegebene Signal besteht in diesem Ausführungsbeispiel aus einer Sequenz von Doppeltönen, die dem Dualton-Wählverfahren bei der Tonwahl von Telefonen entlehnt sind, so dass eine Dekodierung dieser akustischen Signale mit Standardmitteln (DTMF-Empfänger) möglich ist. Dabei wird beispielsweise eine Identifizierungsnummer des Stromrichters bzw. Umrichters U aus einem Engineering für die industrielle Automatisierungsanordnung, in der der Umrichter U und der Motor M angeordnet sind, als Identifizierung per DTMF-Folge übertragen. Das mobile Gerät S (Smartphone) wird durch das Starten einer passenden "App" (Applikationsmodul) in die Lage versetzt, die per eingebautem Mikrofon empfangenen akustischen Schwingungen in eine alphanumerische Ausgabe der kodierten Identifizierungsnummer umzusetzen.

Im vorliegenden Ausführungsbeispiel handelt es sich also um eine akustische Detektion bzw. akustische Identifizierung, wobei das Motorgehäuse der elektrischen Maschine M als Lautsprecher wirkt, wobei das emittierte Geräusch direkt mit dem menschlichen Ohr gehört werden kann oder aber mit dem Mikrofon eines Smartphones oder dergleichen aufgezeichnet bzw. dekodiert werden kann. Durch die Verwendung geeigneter Sensoren ist es auch möglich, akustische Schwingungen im nicht hörbaren Bereich oder auch Körperschall zu verwenden, wobei im letztgenannten Fall das Motorgehäuse zu Schwingungen angeregt werden kann, die mit einem Beschleunigungssensor des mobilen Gerätes aufgezeichnet bzw. verarbeitet werden können.

Alternativ ist es möglich, durch einen von dem Umrichter U initiierten Stromfluss durch zumindest eine Motorwicklung der elektrischen Maschine M ein äußeres Magnetfeld in der Nähe der Maschine M zu generieren, welches durch einen Magnetfeldsensor (z.B. Kompass) des mobilen Gerätes S erfasst werden kann.

In einer weiteren alternativen Variante ist es möglich, eine gleichphasige Ansteuerung einer Motorwicklung oder mehrerer Motorwicklungen vorzunehmen, wodurch kein Stromfluss durch eine Motorwicklung bedingt wird, aber ein von außen detektierbares elektrisches Feld in der Nähe der elektrischen Maschine M erzeugt werden kann, wobei dieses elektrische Feld berührungslos detektiert werden kann. Dazu kann ein Zusatzsensor mit dem mobilen Gerät S verbunden werden, wobei es darüber hinaus auch möglich ist, die durch das elektrische Feld bedingten Einstreuungen in das Mikrofon eines mobilen Gerätes S auch ohne speziellen Zusatzsensor zu erfassen und auszuwerten.

Grundsätzlich macht sich die Erfindung den Grundgedanken zu eigen, dass mit einer gezielten Anregung der Leistungsleitungen eines stehenden Motors oder allgemein einer elektrischen Maschine M durch den Umrichter U ein am Motor oder in der unmittelbaren Nähe des Motors oder der elektrischen Maschine M messbarer Effekt zur Identifizierung entweder der Maschine M oder des steuernden Umrichters U verwendet werden kann. Dabei entfällt das manuelle Durchmessen von Leitungen und es werden auch keine speziellen Modifikationen an der elektrischen Maschine M verwendet, also keine zusätzlichen Signalleitungen, keine zusätzlichen Displays, Sendeeinrichtungen oder dergleichen. Es müssen auch keine spannungsführenden Teile an der Maschine M oder an dem Umrichter U oder an der Leitung L zugegriffen werden, so dass das vorstehend beschriebene Verfahren eine hohe Sicherheit gewährleistet.

## Patentansprüche

1. Verfahren zur Lokalisierung einer an einem Umrichter (U) angeschlossenen elektrischen Maschine (M) oder zur Identifizierung des an der elektrischen Maschine (M) angeschlossenen Umrichters (U),
**dadurch gekennzeichnet,**
**dass** mittels eines Leistungsausgangs des Umrichters (U) die elektrische Maschine (M) mit einem elektrischen Signal beaufschlagt wird,
wobei das elektrische Signal eine derartige Amplitude, Phase und einen derartigen Signalverlauf aufweist, dass die elektrische Maschine (M) zur Abgabe einer mechanischen oder akustischen Schwingung oder zum Aufbau eines magnetischen oder eines elektrischen Feldes in ihrer Umgebung angeregt wird.

2. Verfahren nach Patentanspruch 1,
**dadurch gekennzeichnet,**
**dass** das Signal derart ausgestaltet wird, dass ein Drehen eines Rotors der elektrischen Maschine (M) nicht erfolgt oder eine Beschädigung der elektrischen Maschine (M) durch das Signal ausgeschlossen ist.

3. Verfahren nach einem der vorhergehenden Patentansprüche,
**dadurch gekennzeichnet,**
**dass** das Signal derart ausgebildet wird, dass es anhand seines Signalverlaufs, insbesondere anhand einer Frequenz und/oder anhand eines Pulsmusters, zur Identifizierung nutzbar ist.

4. Verfahren nach einem der vorhergehenden Patentansprüche,
**dadurch gekennzeichnet,**
**dass** die Identifizierung mittels eines mobilen Gerätes (S) mit einem Sensor, insbesondere einem Schwingungssensor für mechanische Schwingungen oder Körperschall, mit einem Mikrofon für akustische Schwingungen, mit einem Magnetfeldsensor für magnetische Felder bzw. magnetische Wechselfelder und/oder mit einem Feldsensor für elektrische Felder durchgeführt wird.

5. Verfahren nach Patentanspruch 4,
**dadurch gekennzeichnet,**
**dass** als das mobile Gerät (S) ein Smartphone, ein Tablet-PC oder ein mobiles Bedien- und Beobachtungsgerät für industrielle Automatisierungsanordnungen verwendet wird.

6. Verfahren nach einem der Patentansprüche 4 oder 5,
**dadurch gekennzeichnet,**
**dass** durch das mobile Gerät (S) mittels einer Software eine Dekodierung des aufgenommenen Signals durchgeführt wird.

7. Verfahren nach Patentanspruch 6,
**dadurch gekennzeichnet,**
**dass** die Software einen Vergleich des von dem Umrichter (U) abgegebenen Signals mit dem mittels des Sensors aufgenommenen Signals durchführt.

8. Verfahren nach Patentanspruch 7,
**dadurch gekennzeichnet,**
**dass** in dem Fall, in dem mehrere Umrichter (U) verschiedene Signale an verschiedene elektrische Maschinen (M) abgeben, durch den Vergleich die Identifizierung des diese Maschine ansteuernden Umrichters (U) erfolgt.

9. Verfahren nach einem der vorhergehenden Patentansprüche,
**dadurch gekennzeichnet,**
**dass** der Umrichter (U) an seinen Ausgangsklemmen ein gleichphasiges Signal abgibt, wobei dieses Signal derart ausgestaltet ist, dass die damit angesteuerte elektrische Maschine (M) ein äußeres elektrisches Feld aufbaut.

10. Umrichter zur Lokalisierung einer an dem Umrichter (U) angeschlossenen elektrischen Maschine oder zur Identifizierung des an der elektrischen Maschine (M) angeschlossenen Umrichters (U),
**dadurch gekennzeichnet,**
**dass** der Umrichter (U) zur Beaufschlagung eines Leistungsausgangs mit einem elektrischen Signal eingerichtet ist,
wobei das elektrische Signal eine derartige Amplitude und einen derartigen Signalverlauf aufweist, dass die elektrische Maschine (M) zur Abgabe einer mechanischen oder akustischen Schwingung oder zum Aufbau eines äußeren elektrischen oder magnetischen Feldes angeregt wird, und
**dass** das Signal derart ausgestaltet ist, dass ein Drehen eines Rotors der elektrischen Maschine (M) nicht erfolgt und/oder eine Beschädigung der elektrischen Maschine (M) durch das Signal ausgeschlossen ist.
